# EUROPEAN PATENT APPLICATION

(11) **EP 4 845 323 A1**
(43) Date of publication of application: **25.11.2026**
(21) Application number: 26176032.6
(22) Date of filing: 01.05.2026
(51) Int. Cl.: H05K 7/20

(54) **TARGETED DYNAMIC FLOW CONTROL FOR MAXIMUM THERMAL MANAGEMENT EFFICIENCY IN DATA CENTERS**

(30) Priority: 23.05.2025 US 202519217839
(71) Applicant: Microsoft Technology Licensing, LLC, Redmond, WA 98052 (US)
(72) Inventor: RAMAKRISHNAN, Bharath, Redmond 98052-6399 (US); ALISSA, Husam, Redmond 98052-6399 (US); ORTEGA GUTIERREZ, Felipe Enrique, Redmond 98052-6399 (US); ABBOTT, Sean Patrick, Redmond 98052-6399 (US); TRIEU, Dennis, Redmond 98052-6399 (US); MISRA, Pulkit Ambikanandan, Redmond 98052-6399 (US); KABBANI, Hussameddine, Redmond 98052-6399 (US); CHIVUKULA VENKATA SAI, Subrahmanya Srinivas, Redmond 98052-6399 (US)
(74) Representative: CMS Cameron McKenna Nabarro Olswang LLP

(57) **Abstract**

A liquid cooling system may include a liquid coolant source. The liquid cooling system may include a first heat-generating computing component of a computing system. The liquid cooling system may include a first flow-regulating device configurable to vary a first flow of liquid coolant from the liquid coolant source to the first heat-generating computing component of computing infrastructure, wherein the liquid coolant circulates to the first heat-generating computing component and back to the liquid coolant source. The liquid cooling system may include a first controller configured to cause the first flow-regulating device to vary the first flow from a first flow rate to a second flow rate based on first utilization data received from the first heat-generating computing component.

## Description

### Background

Thermal management systems employ liquid cooling to manage the temperature of computing devices at data centers, such as data centers that support artificial intelligence (Al) models. In traditional thermal management systems, liquid-cooled servers are managed using a coolant distribution unit (CDU), which typically cools multiple racks of servers. For example, a rack is a physical, open-frame or enclosed structure designed to hold multiple servers and networking equipment in a vertical stack. A cabinet is an enclosed rack that may include doors and side panels.

### Summary

In some aspects, the techniques described herein relate to a liquid cooling system, including: a liquid coolant source; a first heat-generating computing component of a computing system; a first flow-regulating device configurable to vary a first flow of liquid coolant from the liquid coolant source to the first heat-generating computing component of computing infrastructure, wherein the liquid coolant circulates to the first heat-generating computing component and back to the liquid coolant source; and a first controller configured to cause the first flow-regulating device to vary the first flow from a first flow rate to a second flow rate based on first utilization data received from the first heat-generating computing component.

In some aspects, the techniques described herein relate to a method including: receiving first utilization data from a first heat-generating computing component of computing infrastructure; and causing a first flow-regulating device to vary a first flow of liquid coolant from a liquid coolant source to the first heat-generating computing component from a first flow rate to a second flow rate based on the first utilization data, wherein the liquid coolant circulates to the first heat-generating computing component and back to the liquid coolant source.

In some aspects, the techniques described herein relate to one or more tangible processor-readable storage media embodied with instructions for executing on one or more processors and circuits of a computing device a process including: receiving first utilization data from a first heat-generating computing component of computing infrastructure; and causing a first flow-regulating device to vary a first flow of liquid coolant from a liquid coolant source to the first heat-generating computing component from a first flow rate to a second flow rate based on the first utilization data, wherein the liquid coolant circulates to the first heat-generating computing component and back to the liquid coolant source.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

Other implementations are also described and recited herein.

### Brief Descriptions of the Drawings

FIG. 1 illustrates an example computing environment in which a liquid cooling system provides liquid coolant to computing infrastructure based on utilization data of the computing infrastructure.
FIG. 2 illustrates an example computing environment in which a liquid cooling system dynamically provides liquid coolant to components of a server based on utilization data and/or sensor data using server-component-level flow-regulating devices (e.g., flow-regulating device, flow-regulating device).
FIG. 3 illustrates an example computing environment in which a liquid cooling system dynamically regulates the delivery of liquid coolant to multiple heat-generating servers (e.g., N servers, including heat-generating server, heat-generating server, heat-generating server, heat-generating server, ... and heat-generating server) of a rack using server-level flow-regulating devices (e.g., flow-regulating device, flow-regulating device, flow-regulating device).
FIG. 4 illustrates an example computing environment in which a liquid cooling system dynamically regulates the delivery of liquid coolant to multiple racks (e.g., rack, rack, rack) of heat-generating servers using rack-level flow-regulating devices (e.g., flow-regulating device, flow-regulating device, flow-regulating device).
FIG. 5 illustrates an example computing environment in which a liquid cooling system dynamically regulates the delivery of liquid coolant to multiple racks (e.g., rack, rack, rack) of heat-generating servers using both rack-level flow-regulating devices (e.g., flow-regulating device, flow-regulating device, flow-regulating device) and server-level flow-regulating devices (e.g., flow-regulating device, flow-regulating device, flow-regulating device, flow-regulating device, ... and flow-regulating device).
FIG. 6 depicts a computing environment in which a microcontroller of a flow-regulating device adjusts a flow rate of liquid coolant for a component of computing infrastructure based on sensor data.
FIG. 7 depicts a process for adjusting, using a proportional-integral (PI) controller, a flow-regulating device to modify a flow rate of liquid coolant for a component of computing infrastructure.
FIG. 8 depicts a process for adjusting a flow rate of liquid coolant for a component of computing infrastructure based on sensor data.
FIG. 9 depicts examples of operations for providing liquid coolant to computing infrastructure based on utilization data of the computing infrastructure.
FIG. 10 illustrates an example computing device for use in implementing the described technology.

### Detailed Descriptions

In traditional thermal management systems, the CDU may employ flow-limiting valves to distribute the liquid coolant using differential pressure changes to ensure all the racks receive the same liquid flow. The CDU of traditional thermal management systems may control the flow of the liquid coolant through the racks such that the liquid coolant that is circulated out of the racks is maintained within a predetermined temperature range. However, such whole-computing-system approaches do not adequately cool individual components (e.g., individual racks, servers, and server components) of the computing system. For example, the individual racks of the computing system, the individual servers within racks, and the individual subcomponents (e.g., chips) of the servers may generate heat at varying levels because of different device structure and/or operational patterns. The traditional whole-system cooling approach, which ensures a consistent flow of liquid coolant among all racks of the computing system, does not address spatially inconsistent thermal profiles. Accordingly, overheated sub-areas of the computing system do not receive adequate cooling in traditional thermal management approaches that apply a predetermined flow rate of liquid coolant throughout the entire computing system.

The technology disclosed herein addresses the inadequacies of traditional thermal management systems by providing a CDU that includes flow-regulating devices for modifying the liquid coolant flow rate at one or more subregions (e.g., racks, servers, server subcomponents) of the data center and flow-regulating controllers for modifying the flow rate, differential pressure, and/or temperature of the liquid coolant at the different subregions using the flow-regulating devices responsive to changing conditions of the different subregions. The flow-regulating controllers of the disclosed technology can monitor temperature sensors at the subregions and control, using the flow-regulating devices, parameters (e.g., flow rate, pressure, temperature) of liquid coolant delivery to each subregion to maintain the temperature of the subregion within a predetermined temperature range. Also, the flow-regulating controllers of the disclosed technology can monitor state data (e.g., workload metrics) and control, using the flow-regulating devices, parameters (e.g., flow rate, pressure, temperature) of liquid coolant delivery to each subregion responsive to the detected state data to maintain the temperature of the subregion within a predetermined temperature range. For example, a flow-regulating controller of the disclosed technology can deliver an increased flow rate of coolant to two specific servers responsive to detecting an increase in the processing workload of the two specific servers to counteract an anticipated increase in temperature due to the increased processing workload. Accordingly, the thermal management approach of the disclosed technology adequately provides thermal management for data centers having subregions with differing thermal profiles, which is not achieved using traditional thermal management approaches

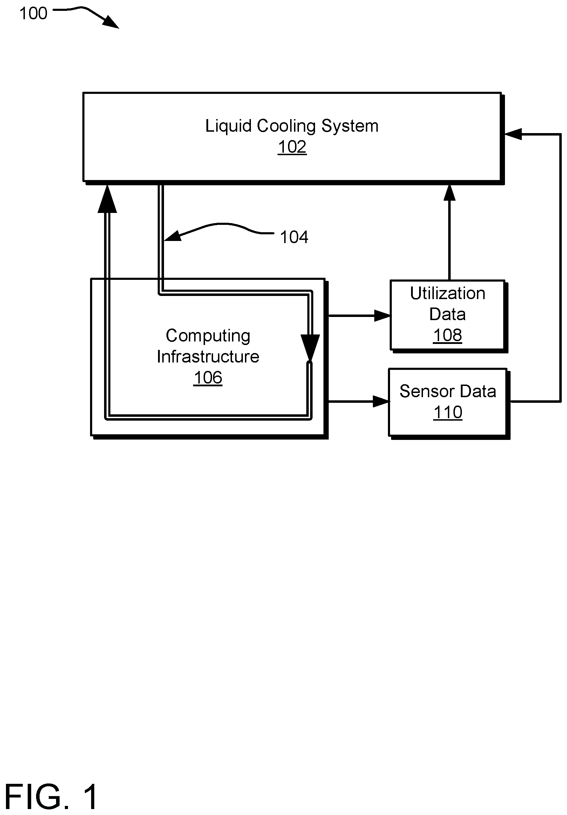

FIG. 1 illustrates an example computing environment 100 in which a liquid cooling system 102 provides liquid coolant to computing infrastructure 106 based on utilization data 108 of the computing infrastructure 106. The computing environment 100 includes the liquid cooling system 102 and the computing infrastructure 106. The liquid cooling system 102 provides a flow 104 of liquid coolant that is circulated among the computing infrastructure 106 to thermally regulate the computing infrastructure 106. Thermal regulation may include cooling the computing infrastructure 106 as needed so that the temperature of the computing infrastructure 106 is maintained within a predetermined temperature range. The flow 104 of the liquid coolant may be directed through coolant lines (e.g., piping, tubing, hoses, cold plates, or other lines) that contact surfaces of computing devices, storage devices, or other heat-generating hardware devices of the computing infrastructure 106 so that heat is transferred from the heat-generating hardware devices to the liquid coolant, cooling the computing infrastructure 106 that contacts the coolant lines. A liquid coolant source (e.g., reservoir) of the liquid cooling system 102 may include a heat exchanger that cools the liquid coolant before the liquid coolant circulates through the flow 104 and after it returns to the liquid coolant source. The liquid cooling system 102 may include a coolant distribution unit (CDU) that includes one or more pumps that maintain the flow 104 of the liquid coolant.

The liquid cooling system 102 may receive sensor data 110 from one or more sensors in proximity to the flow 104. For example, the sensor data 110 may include temperature readings from temperature sensors that detect temperatures of the liquid coolant or of liquid coolant lines along the flow 104. The sensor data 110 may include temperature readings from temperature sensors that detect temperatures of one or more computing devices, storage devices, or other hardware of the computing infrastructure 106. (e.g., chip temperature sensors). The sensor data 110 may include pressure readings from pressure sensors that detect pressures of the flow 104 of the liquid coolant at one or more locations along the flow 104.

The liquid cooling system 102 may receive utilization data 108 from one or more computing devices, storage devices, or other hardware of the computing infrastructure 106. For example, the utilization data 108 may be from processing devices (e.g., GPUs, CPUs, controllers, microcontrollers, or other processors) corresponding to computing device components, computing devices, storage devices, or other hardware of the computing infrastructure 106. The utilization data 108 may include metrics that measure how actively resources (e.g., processors, memory, storage, network bandwidth, or power) of the processing devices are being used over time. The utilization data 108 may capture a percentage or proportion of available capacity of resources that are currently in use, helping operators understand workload demand, system efficiency, and potential bottlenecks. The utilization data 108 may be gathered through monitoring tools and telemetry systems that track how much of a resource's total capacity is being consumed at a given time or across a defined interval. For processors (CPUs, GPUs, or other specialized compute units), the utilization data 108 might be expressed as a percentage of compute cycles in use. For memory and storage, the utilization data 108 may reflect the proportion of available capacity occupied by active processes, cached data, or stored files. For network resources, the utilization data 108 may measure the volume of data transmitted relative to the maximum throughput capacity of a connection. The utilization data 108 may indicate heat-generating components of the computing infrastructure 106. For example, when computing resources like CPUs, GPUs, and other processors actively perform processing operations, they consume electrical power. A significant portion of that power may be converted into heat as a byproduct (e.g., due to electrical resistance within the silicon and supporting circuitry). The higher the utilization, the more power they draw, and consequently, the more heat they produce.

The liquid cooling system 102 may modify the flow 104 (e.g., by increasing or decreasing the flow 104 at one or more heat-generating components of the computing infrastructure 106. The liquid cooling system 102 may modify the flow 104 (e.g., at one or more liquid coolant lines) based on one or more of the sensor data 110 or the utilization data 108. For example, the liquid cooling system 102 may modify the flow 104 by increasing or decreasing a flow rate at one or more locations of the flow 104 until subsequent sensor data indicates that the temperature falls within a predetermined temperature range. In some implementations, the liquid cooling system 102 assesses the difference between a predetermined setpoint that specifies one or more of or a combination of a target flow rate, a pressure level, and a temperature. For example, the setpoint may be determined from a combination of flow, pressure, and temperature sensors and may be determined by applying a logical function. The liquid cooling system may modify the flow rate of the flow 104 using flow-regulating devices at one or more locations along the flow 104. Pressure regulations may include, but are not limited to, valves and variable pumps.

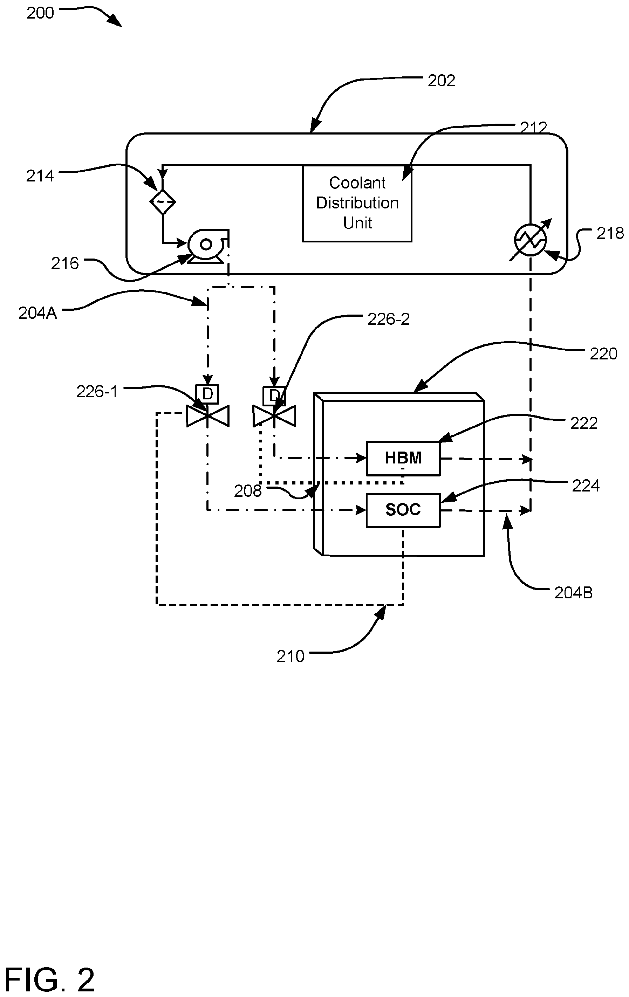

FIG. 2 illustrates an example computing environment 200 in which a liquid cooling system 202 dynamically provides liquid coolant to components of a server 220 based on utilization data and/or sensor data using server-component-level flow-regulating devices (e.g., flow-regulating device 226-1, flow-regulating device 226-2). For example, the server 220 is a component of computing infrastructure for which the liquid cooling system 202 provides thermal regulation.

The computing environment 200 includes a liquid cooling system 202, a server 220, coolant lines (e.g., input coolant lines 204A and output coolant lines 204B), and flow-regulating devices (e.g., flow-regulating device 226-1, flow-regulating device 226-2).

The example server 220 is configured to process high-performance, data-intensive workloads, integrating a heat-generating component 224 (e.g., system on chip (SOC)) and a heat-generating component 222 (e.g., a High Bandwidth Memory (HBM) module). For example, the server 220 provides low-latency, high-throughput processing capabilities, optimized for AI inference, machine learning training, scientific simulations, and/or big data analytics. For example, the HBM generates heat by rapidly transferring large amounts of data across wide memory buses at high frequencies, causing energy loss in the form of thermal dissipation within the memory stacks and interconnects. The SOC generates heat by the continuous operation of densely packed processing cores, accelerators, and integrated controllers, where electrical resistance in transistors and interconnects converts electrical energy into thermal energy during computation.

The server 220 and its heat-generating components are examples. The implementations described herein can be applied to provide cooling for a variety of types heat-generating components, for example, including but not limited to a CPU, a GPU, a power supply unit (PSU), a voltage regulation module (VRM), a network interface card (NIC), or other heat-generating component that generates heat as a byproduct of its operations.

The liquid cooling system 202 includes a coolant distribution unit 212. The coolant distribution unit 212 includes a pump 216, a filtration system 214, and a heat exchanger 218. The liquid cooling system 202 thermally regulates the temperature of heat-generating components (e.g., heat-generating component 222 and heat-generating component 224) of the server 220 by circulating liquid coolant through the coolant lines. Thermally regulating the temperature may involve maintaining a temperature of each of the heat-generating components within a predetermined temperature range by cooling the heat-generating components with liquid coolant provided by liquid coolant lines (e.g., the input coolant lines 204A and the output coolant lines 204B). For example, the predetermined temperature range may include a maximum temperature, for example, 60°C, 80°C, 95°C, or other predetermined maximum temperature. The predetermined temperature range may be predetermined based on the type of heat-generating component (e.g., CPU, GPU, etc.) to ensure that the heat-generating component does not suffer a decline in performance and/or is not damaged via overheating.

The coolant distribution unit 212 regulates, distributes, and manages the flow of the liquid coolant and monitors temperatures, controls flow rates, and interfaces with external cooling infrastructure (e.g., facility water) to safely remove heat absorbed by the liquid coolant from the heat-generating components (e.g., the heat-generating component 222 and the heat-generating component 224) of the server 220.

The pump 216 generates a pressure difference that pushes the liquid coolant through the liquid coolant lines (e.g., the input coolant lines 204A and the output coolant lines 204B), for example, by mechanically moving liquid from a low-pressure intake to a high-pressure discharge area, using components like impellers, pistons, or gears to create flow and force against system resistance.

The coolant lines may contact surfaces of the heat-generating components of the server 220 so that heat is transferred from the heat-generating components to the liquid coolant, cooling the server 220 that contacts the coolant lines. The input coolant lines 204A channel a flow of liquid coolant to the server components, and the output coolant lines 204B channel the flow of the liquid coolant from the server components back to the liquid cooling system 202.

The heat exchanger 218 transfers heat from the warm coolant received via output coolant lines 204B to a secondary medium, such as air or another liquid, without mixing the warm coolant and the secondary medium. This heat transfer process removes heat from the liquid coolant, causing the liquid coolant to cool.

The filtration system 214 removes particulates, debris, and contaminants from the liquid coolant to maintain fluid purity and prevent blockages or damage to sensitive components. For example, the filtration system 214, as illustrated in FIG. 2, may receive the cooled liquid coolant that is cooled by the heat exchanger 218 and filter it before it is recirculated through the coolant lines by the pump 216.

The flow-regulating devices (e.g., the flow-regulating device 226-1 and the flow-regulating device 226-2) are configurable to regulate the pressure of the liquid coolant that is provided via input coolant lines 204A to cool heat-generating components of the server 220. As illustrated in FIG. 2, the flow-regulating devices (e.g., the flow-regulating device 226-1 and the flow-regulating device 226-2) receive information corresponding to the heat-generating components. The information may include utilization information and sensor data. For example, the flow-regulating device 226-1 receives sensor data 210 from the heat-generating component 224 and the flow-regulating device 226-2 receives utilization data 208 from the heat-generating component 222. Based on the received information corresponding to the heat-generating components, the flow-regulating devices adjust a pressure of the liquid coolant flow to the corresponding heat-generating components.

Responsive to receiving utilization data 208 indicating an increase in utilization (e.g., a memory bandwidth of the HBM) of the heat-generating component 222, the flow-regulating device 226-2 increases a pressure of the liquid coolant delivered to the heat-generating component 222, increasing the extent of cooling provided to the heat-generating component 222. In this example, responsive to receiving utilization data 208 indicating a decrease in utilization of the heat-generating component 222, the flow-regulating device 226-2 decreases a pressure of the liquid coolant delivered to the heat-generating component 222, decreasing the amount of cooling provided to the heat-generating component 222.

Responsive to receiving sensor data 210 indicating an increase in temperature of the heat-generating component 224 to outside of a maximum temperature of a predetermined temperature range, the flow-regulating device 226-1 increases a pressure of the liquid coolant delivered to the heat-generating component 224, increasing the extent of cooling provided to the heat-generating component 224. In this example, responsive to receiving sensor data 210 indicating a decrease in temperature of the heat-generating component 224, the flow-regulating device 226-1 decreases a pressure of the liquid coolant delivered to the heat-generating component 224, decreasing the amount of cooling provided to the heat-generating component 224.

In some implementations, one or more flow-regulating devices receive both utilization data (e.g., the utilization data 208) and sensor data (e.g., the sensor data 210) from corresponding heat-generating components and may adjust the pressure of the liquid coolant provided to the heat-generation components based on one or more of the utilization data and the sensor data.

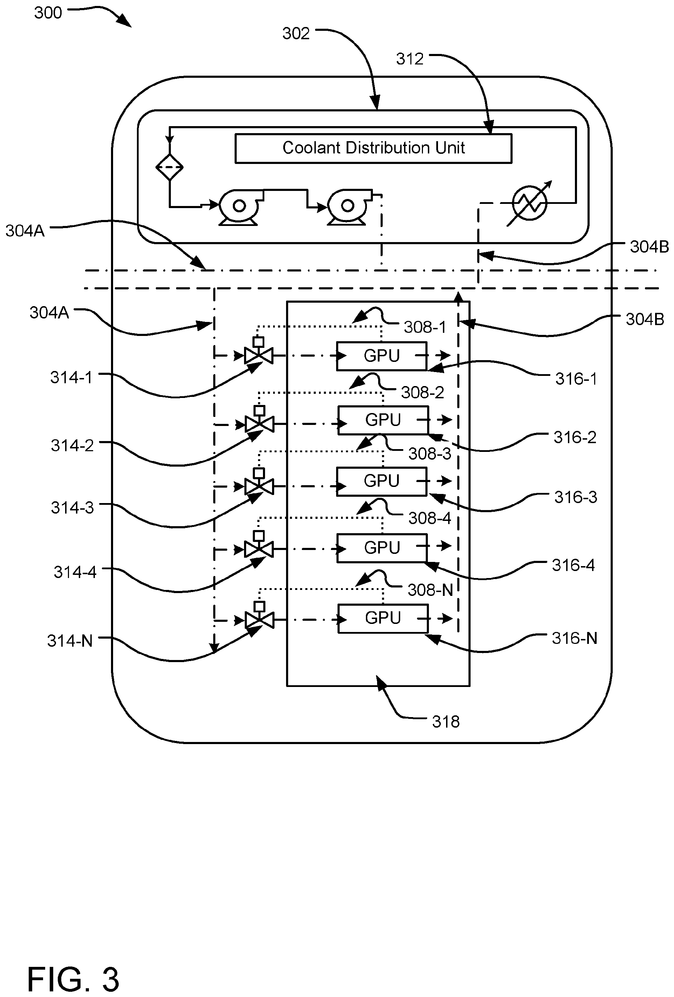

FIG. 3 illustrates an example computing environment 300 in which a liquid cooling system 302 dynamically regulates the delivery of liquid coolant to multiple heat-generating servers (e.g., N servers, including heat-generating server 316-1, heat-generating server 316-2, heat-generating server 316-3, heat-generating server 316-4, ... and heat-generating server 316-N) of a rack 318 using server-level flow-regulating devices (e.g., flow-regulating device 314-1, flow-regulating device 314-2, flow-regulating device 314-3).

The N heat-generating servers of the rack 318 are a component of computing infrastructure for which the liquid cooling system 302 provides thermal regulation. The rack 318 may be a frame that holds the N heat-generating servers (e.g., the heat-generating server 316-1, the heat-generating server 316-2, the heat-generating server 316-3, the heat-generating server 316-4, ... and the heat-generating server 316-N). The N heat-generating servers generate heat as a byproduct of their operations (e.g., including operations of components like CPUs, GPUs, memory, and power regulators, etc.).

The liquid cooling system 302 includes a coolant distribution unit 312 that regulates, distributes, and manages the flow of the liquid coolant and monitors temperatures, controls flow rates, and interfaces with external cooling infrastructure (e.g., facility water) to safely remove heat absorbed by the liquid coolant from the N heat-generating servers. The coolant distribution unit 312 may include a filtration system, one or more pumps, and a heat exchanger.

The liquid cooling system 302 thermally regulates the temperature of the N heat-generating servers of the rack 318 by circulating liquid coolant through the coolant lines. Thermally regulating the temperature may involve maintaining a temperature of each of the heat-generating servers of the rack 318 within a predetermined temperature range by cooling the heat-generating servers with liquid coolant provided by liquid coolant lines (e.g., input coolant lines 304A and the output coolant lines 304B). The coolant lines may contact surfaces of the heat-generating servers so that heat is transferred from the heat-generating servers to the liquid coolant, cooling the heat-generating servers that contact the coolant lines. The input coolant lines 304A channel a flow of liquid coolant to the heat-generating servers, and the output coolant lines 304B channel the flow of the liquid coolant from the heat-generating servers back to the liquid cooling system 302.

The liquid cooling system 302 includes flow-regulating devices (e.g., flow-regulating device 314-1, flow-regulating device 314-2, flow-regulating device 314-3, flow-regulating device 314-4, ... and flow-regulating device 314-N) corresponding to the heat-generating servers (e.g., the heat-generating server 316-1, the heat-generating server 316-2, the heat-generating server 316-3, the heat-generating server 316-4, ... and the heat-generating server 316-N). The flow-regulating devices are configurable to regulate the pressure of the liquid coolant that is provided via input coolant lines 304A to cool heat-generating servers.

As illustrated in FIG. 3, the flow-regulating devices (e.g., flow-regulating device 314-1, flow-regulating device 314-2, flow-regulating device 314-3, flow-regulating device 314-4, ... and flow-regulating device 314-N) receive information corresponding to the heat-generating servers. The information may include utilization information and sensor data. For example, the flow-regulating device 314-1 receives utilization data 308-1 from the heat-generating server 316-1, the flow-regulating device 314-2 receives utilization data 308-2 from the heat-generating server 316-2, the flow-regulating device 314-3 receives utilization data 308-3 from the heat-generating server 316-3, the flow-regulating device 314-4 receives utilization data 308-4 from the heat-generating server 316-4, and so forth.

The flow-regulating device 314-N receives utilization data 308-N from the heat-generating server 316-N. Each of the flow-regulating devices (e.g., flow-regulating device 314-1) may adjust the liquid coolant pressure to its corresponding heat-generating server (e.g., the heat-generating server 316-1) based on the received utilization information (e.g., the utilization data 308-1). Accordingly, due to different amounts of heat generated by the heat-generating servers of the rack 318, a first flow-regulating device (e.g., the flow-regulating device 314-1) may deliver liquid coolant to a first server (e.g., the server 316-1) at a different pressure than a second flow-regulating device (e.g., the flow-regulating device 314-2) delivers liquid coolant to a second server (e.g., the server 316-2).

For example, responsive to receiving utilization data 308-1 indicating an increase in utilization (e.g., CPU utilization) of the heat-generating server 316-1, the flow-regulating device 314-1 increases a pressure of the liquid coolant delivered to the heat-generating server 316-1, increasing the extent of cooling provided to the heat-generating server 316-1. In this example, responsive to receiving utilization data 308-1 indicating a decrease in utilization of the heat-generating server 316-1, the flow-regulating device 314-1 decreases a pressure of the liquid coolant delivered to the heat-generating server 316-1, decreasing the amount of cooling provided to the heat-generating server 316-1.

In some implementations, one or more of the flow-regulating devices may, in addition to or instead of utilization data, receive sensor data corresponding to the heat-generating servers. In these implementations, the flow-regulating devices may adjust the pressure of liquid coolant delivered to the heat-generating servers of the rack based on one or more of the utilization data or the sensor data.

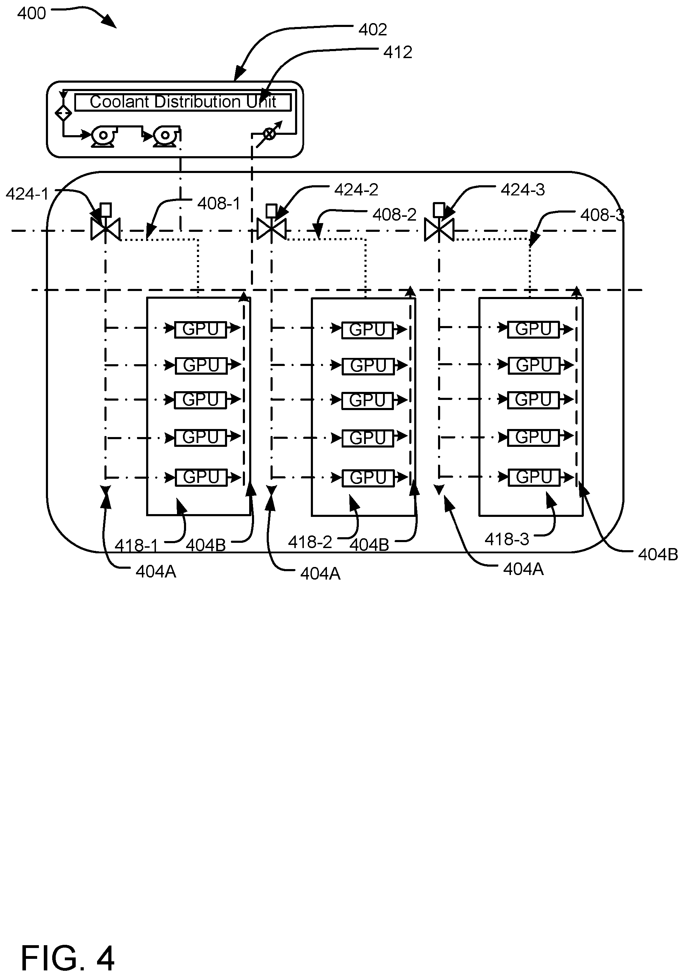

FIG. 4 illustrates an example computing environment 400 in which a liquid cooling system 402 dynamically regulates the delivery of liquid coolant to multiple racks (e.g., rack 418-1, rack 418-2, rack 418-3) of heat-generating servers using rack-level flow-regulating devices (e.g., flow-regulating device 424-1, flow-regulating device 424-2, flow-regulating device 424-3).

For example, each of the rack is a component of computing infrastructure for which the liquid cooling system 402 provides thermal regulation. Each of the racks is a frame that holds heat-generating servers. The heat-generating servers generate heat as a byproduct of their operations (e.g., including operations of components like CPUs, GPUs, memory, and power regulators, etc.).

The liquid cooling system 402 includes a coolant distribution unit 312 that regulates, distributes, and manages the flow of the liquid coolant and monitors temperatures, controls flow rates, and interfaces with external cooling infrastructure (e.g., facility water) to safely remove heat absorbed by the liquid coolant from the heat-generating servers. The coolant distribution unit 412 may include a filtration system, one or more pumps, and a heat exchanger.

The liquid cooling system 402 thermally regulates the temperature of the heat-generating servers of the racks (e.g., the rack 418-1, the rack 418-2, the rack 418-3) by circulating liquid coolant through coolant lines. Thermally regulating the temperature may involve maintaining a temperature of each of the heat-generating servers of the racks within a predetermined temperature range by cooling the heat-generating servers with liquid coolant provided by the liquid coolant lines (e.g., input coolant lines 404A and the output coolant lines 404B). The coolant lines may contact surfaces of the heat-generating servers so that heat is transferred from the heat-generating servers to the liquid coolant, cooling the heat-generating servers that contact the coolant lines. The input coolant lines 404A channel a flow of liquid coolant to the heat-generating servers, and the output coolant lines 404B channel the flow of the liquid coolant from the heat-generating servers back to the liquid cooling system 302.

The liquid cooling system 402 includes flow-regulating devices (e.g., flow-regulating device 424-1, flow-regulating device 424-2, flow-regulating device 424-3) corresponding to the racks (e.g., the rack 418-1, the rack 418-2, the rack 418-3). The flow-regulating devices are configurable to regulate the pressure of the liquid coolant that is provided via input coolant lines 404A to cool heat-generating servers of the racks. As illustrated in FIG. 4, the flow-regulating devices (e.g., flow-regulating device 424-1, flow-regulating device 424-2, flow-regulating device 424-3) receive information corresponding to the heat-generating servers of the corresponding racks. The information may include utilization information and sensor data. For example, the flow-regulating device 424-1 receives utilization data 408-1 from the heat-generating servers of the rack 418-1, the flow-regulating device 424-2 receives utilization data 408-2 from the heat-generating servers of the rack 418-2, and the flow-regulating device 424-3 receives utilization data 408-3 from the heat-generating servers of the rack 418-3. Each of the flow-regulating devices (e.g., the flow-regulating device 424-1) may adjust the liquid coolant pressure to its corresponding rack (e.g., the rack 418-1) of heat-generating servers based on the received utilization information (e.g., the utilization data 408-1). The flow-regulating device 424-1 may determine a mean, a median, a mode, a weighted mean, or other representative utilization based on the utilization data received from each of the heat-generating servers of the rack 418-1 and the flow-regulating device 424-1 adjusts the pressure of the liquid coolant delivered to the rack 418-1 of servers based on the representative utilization.

In some implementations, one or more of the flow-regulating devices (e.g., flow-regulating device 424-1, flow-regulating device 424-2, flow-regulating device 424-3) may, in addition to or instead of utilization data, receive sensor data corresponding to the heat-generating servers of the corresponding racks. In these implementations, the flow-regulating devices may adjust the pressure of liquid coolant to the heat-generating servers of the racks based on one or more of the utilization data or the sensor data.

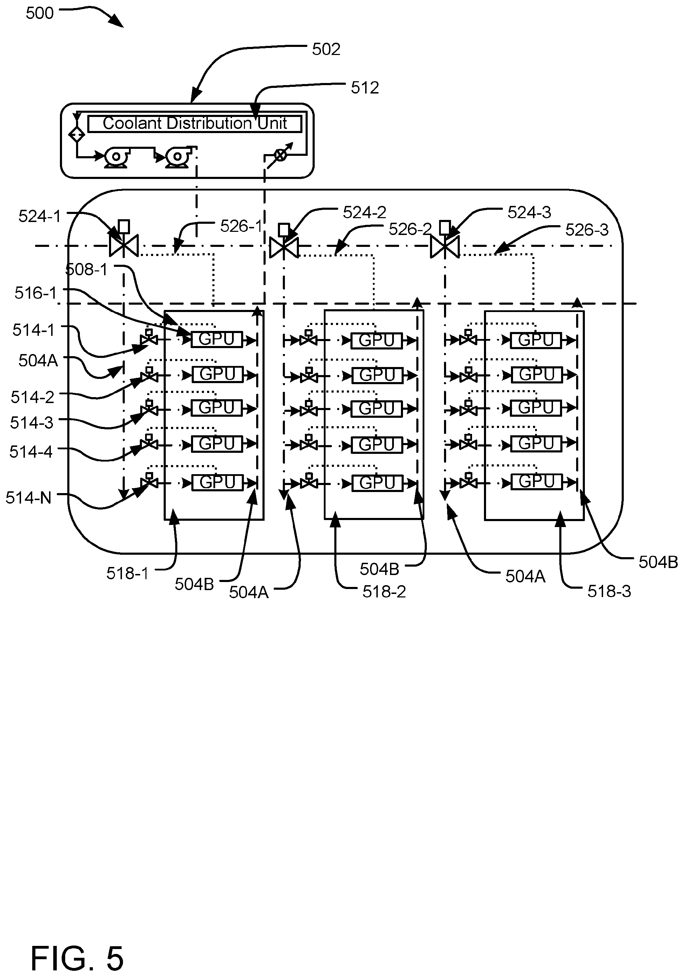

FIG. 5 illustrates an example computing environment 500 in which a liquid cooling system 502 dynamically regulates the delivery of liquid coolant to multiple racks (e.g., rack 518-1, rack 518-2, rack 518-3) of heat-generating servers using both rack-level flow-regulating devices (e.g., flow-regulating device 524-1, flow-regulating device 524-2, flow-regulating device 524-3) and server-level flow-regulating devices (e.g., flow-regulating device 514-1, flow-regulating device 514-2, flow-regulating device 514-3, flow-regulating device 514-4, ... and flow-regulating device 514-N).

For example, each of the racks is a component of computing infrastructure for which the liquid cooling system 502 provides thermal regulation. Each of the racks is a frame that holds heat-generating servers. The heat-generating servers generate heat as a byproduct of their operations (e.g., including operations of components like CPUs, GPUs, memory, and power regulators, etc.).

The liquid cooling system 502 includes a coolant distribution unit 512 that regulates, distributes, and manages the flow of the liquid coolant and monitors temperatures, controls flow rates, and interfaces with external cooling infrastructure (e.g., facility water) to safely remove heat absorbed by the liquid coolant from the heat-generating servers. The coolant distribution unit 512 may include a filtration system, one or more pumps, and a heat exchanger.

The liquid cooling system 502 thermally regulates the temperature of the heat-generating servers of the racks (e.g., the rack 518-1, the rack 518-2, the rack 518-3) by circulating liquid coolant through coolant lines. Thermally regulating the temperature may involve maintaining a temperature of each of the heat-generating servers of the racks within a predetermined temperature range by cooling the heat-generating servers with liquid coolant provided by the liquid coolant lines (e.g., input coolant lines 504A and the output coolant lines 504B). The coolant lines may contact surfaces of the heat-generating servers so that heat is transferred from the heat-generating servers to the liquid coolant, cooling the heat-generating servers that contact the coolant lines. The input coolant lines 504A channel a flow of liquid coolant to the heat-generating servers, and the output coolant lines 504B channel the flow of the liquid coolant from the heat-generating servers back to the liquid cooling system 502.

The liquid cooling system 502 includes rack-level flow-regulating devices (e.g., flow-regulating device 524-1, flow-regulating device 524-2, flow-regulating device 524-3) corresponding to the racks (e.g., the rack 518-1, the rack 518-2, the rack 518-3). The rack-level flow-regulating devices are configurable to regulate the pressure of the liquid coolant that is provided via input coolant lines 504A to cool heat-generating servers of the corresponding racks. As illustrated in FIG. 5, the rack-level flow-regulating devices (e.g., flow-regulating device 524-1, flow-regulating device 524-2, flow-regulating device 524-3) receive information corresponding to the heat-generating servers of the corresponding racks. The information may include utilization information and sensor data. For example, the flow-regulating device 524-1 receives utilization data 526-1 from the heat-generating servers of the rack 518-1, the flow-regulating device 524-2 receives utilization data 526-2 from the heat-generating servers of the rack 518-2, and the flow-regulating device 524-3 receives utilization data 526-3 from the heat-generating servers of the rack 518-3. Each of the rack-level flow-regulating devices (e.g., the flow-regulating device 524-1) may adjust the liquid coolant pressure to its corresponding rack (e.g., the rack 518-1) of heat-generating servers based on the received utilization information (e.g., the utilization data 526-1). The flow-regulating device 524-1 may determine a mean, a median, a mode, a weighted mean, or other representative utilization based on the utilization data received from each of the heat-generating servers of the rack 518-1 and the flow-regulating device 524-1 adjusts the pressure of the liquid coolant delivered to the rack 518-1 of servers based on the representative utilization.

In some implementations, one or more of the rack-level flow-regulating devices (e.g., flow-regulating device 524-1, flow-regulating device 524-2, flow-regulating device 524-3) may, in addition to or instead of utilization data, receive sensor data corresponding to the heat-generating servers of the corresponding racks. In these implementations, the rack-level flow-regulating devices may adjust the pressure of liquid coolant to the heat-generating servers of the racks based on one or more of the utilization data or the sensor data.

The liquid cooling system 502 includes server-level flow-regulating devices (e.g., flow-regulating device 514-1, flow-regulating device 514-2, flow-regulating device 514-3, flow-regulating device 514-4, ... and flow-regulating device 514-N) corresponding to heat-generating servers of a rack (e.g., the rack 518-1). The server-level flow-regulating devices are configurable to regulate the pressure of the liquid coolant that is provided via input coolant lines 504A to cool heat-generating servers.

As illustrated in FIG. 5, the server-level flow-regulating devices (e.g., flow-regulating device 514-1, flow-regulating device 514-2, flow-regulating device 514-3, flow-regulating device 514-4, ... and flow-regulating device 514-N) receive information corresponding to the heat-generating servers. The information may include utilization information and sensor data. For example, the flow-regulating device 514-1 receives utilization data 508-1 from the heat-generating server 516-1, and so forth. Each of the server-level flow-regulating devices (e.g., flow-regulating device 514-1) may adjust the liquid coolant pressure to its corresponding heat-generating server (e.g., the heat-generating server 516-1) based on the received utilization information (e.g., the utilization data 508-1). Accordingly, due to different amounts of heat generated by the heat-generating servers of the rack (e.g., rack 518-1), a first server-level flow-regulating device (e.g., the flow-regulating device 514-1) may deliver liquid coolant to a first server (e.g., the heat-generating server 516-1) at a different pressure than a second flow-regulating device delivers liquid coolant to a second server of the same rack (e.g., the rack 518-1).

In some implementations, one or more of the server-level flow-regulating devices (e.g., flow-regulating device 514-1, flow-regulating device 514-2, flow-regulating device 514-3, flow-regulating device 514-4, ... and flow-regulating device 514-N) may, in addition to or instead of utilization data, receive sensor data corresponding to their corresponding heat-generating servers. In these implementations, the server-level flow-regulating devices may adjust the pressure of liquid coolant to their corresponding heat-generating servers based on one or more of the utilization data or the sensor data.

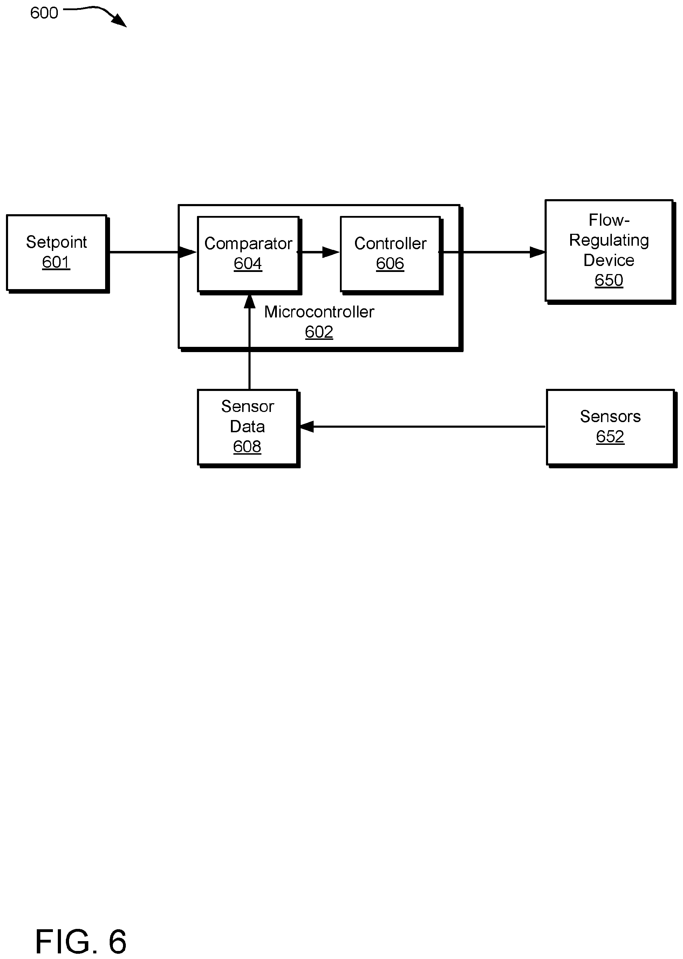

FIG. 6 depicts a computing environment 600 in which a microcontroller of a flow-regulating device adjusts a flow rate of liquid coolant for a component of computing infrastructure based on sensor data. For example, the component is a heat-generating component (e.g., an SOC, a CPU, an HDM, or other heat-generating component) of a server, a server, a rack of servers, multiple racks of servers, or other component of the computing infrastructure and the flow-regulating device may adjust a flow rate of liquid coolant to the component. For example, the microcontroller depicted in FIG. 6 may be implemented to control a server-component-level flow-regulating device, a server-level flow-regulating device, a rack-level flow-regulating device, a multi-rack-level flow-regulating device, or for flow-regulating device corresponding to another heat-generating subdivision (e.g., a first portion of servers of a rack) of the computing infrastructure.

The computing environment 600 includes a microcontroller 602. The microcontroller 602 includes a comparator 604 and a controller 606. The comparator 604 receives or otherwise accesses a setpoint 601 corresponding to the component of the computing infrastructure. For example, the setpoint 601 is based on a target flow rate, a pressure level, and a temperature of component that is predetermined for the computing infrastructure. The comparator 604 also receives sensor data (e.g., flow rate, pressure level, temperature of the liquid coolant, and/or temperature of the component of the computer infrastructure) for the component of the computing infrastructure from one or more sensors 652. The comparator 604 compares the sensor data and the setpoint 601 and determines a difference between the sensor data and the setpoint 601.

The controller 606 adjusts the flow rate of the flow-regulating device 650 based on the difference between the setpoint 601 and sensor data 608 compared by the comparator 604. For example, the controller 606 adjusts (e.g., increases, decreases, or maintains) the flow rate of the liquid coolant to the component of the computing infrastructure in order to achieve the setpoint 601.

The microcontroller 602 may continuously receive the sensor data 608, compare the sensor data 608 (e.g., using the comparator 604) to the setpoint 601, and adjusting (e.g., using the controller 606) the flow rate of the liquid coolant to the component of the computing infrastructure using the flow-regulating device so that the sensor data 608 approaches the setpoint 601 over time.

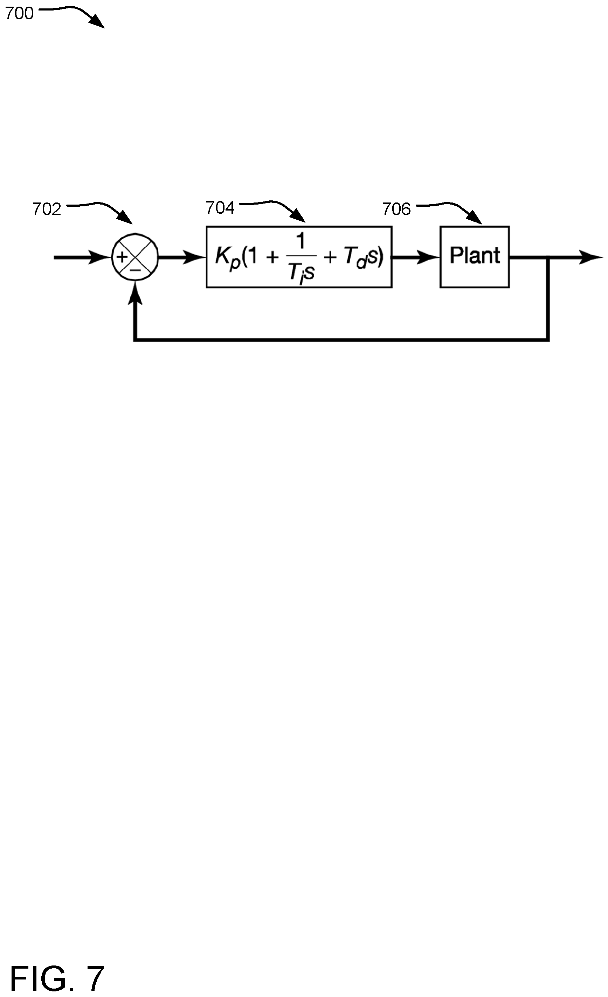

FIG. 7 depicts a process 700 for adjusting, using a proportional-integral (PI) controller, a flow-regulating device to modify a flow rate of liquid coolant for a component of computing infrastructure. The plant 706 represents the system or process that is being controlled, for example, the process adjusting, using a flow-regulating device, the flow rate of liquid coolant to a component of computing infrastructure. The role of the PI controller is to continuously adjust the input to the plant 706 based on the error 702 (the difference between a predetermined setpoint and the actual temperature/pressure/flowrate) to make the system behave as desired. The controller takes in the error signal, processes it using the proportional and integral actions, and generates a control signal that is sent to the plant to correct the output. The proportional gain 704 (Kp) is a constant that determines how strongly the controller reacts to the error 702. For example, the plant 706 receives the control output (based on a product of the error 702 and the proportional gain 704) generated by the controller. This control output adjustment is the change that the system applies to its input, like adjusting a motor's speed (e.g., of a pump-based flow-regulating device, for example, a variable pump) or a valve's position (e.g., of a valve-based flow-regulating device).

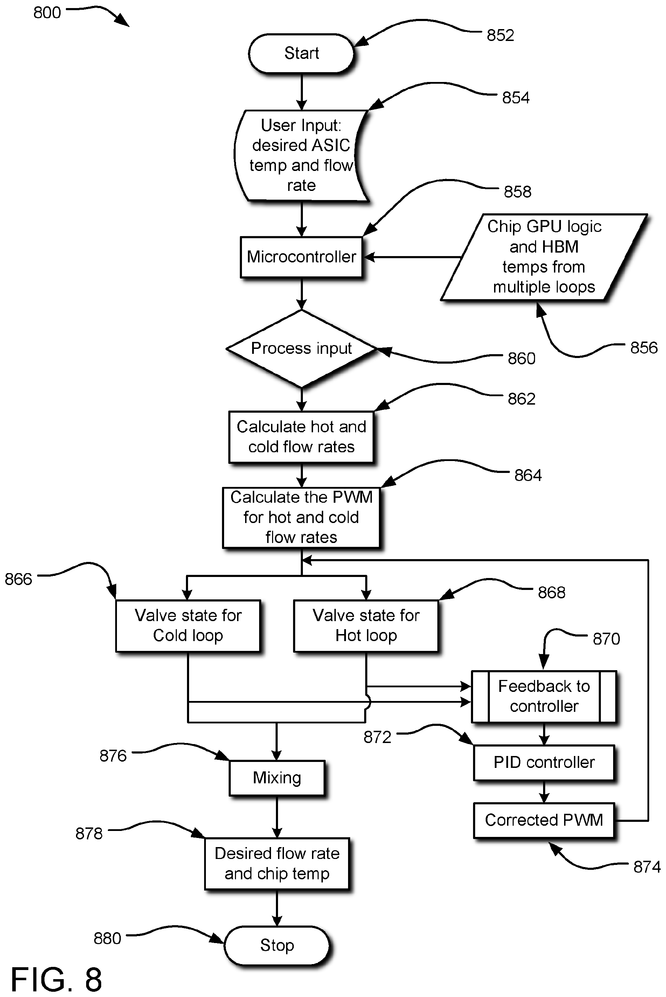

FIG. 8 depicts a process 800 for adjusting a flow rate of liquid coolant for a component of computing infrastructure based on sensor data. The process 800 starts at block 852. At block 854, a user inputs a desired temperature and flow rate to an application-specific integrated circuit (ASIC), for example a setpoint for liquid coolant delivery to a component of computing infrastructure. At block 856, component temperatures (e.g., GPU and HBM) are determined using sensors and, at block 858, a microcontroller (e.g., a PI controller) receives the setpoint and the component temperatures. At block 860, the microcontroller processes the inputs received at block 858 and, at block 862, calculates hot and cold flow rates. At block 864, the microcontroller calculates the PWM for the hot and cold flow rates. For example, in some implementations, multiple flow regulating devices mix various flows of liquid coolant at various temperatures to achieve a predetermined temperature of the liquid coolant for at least a portion of the flow that results from the mixing. For example, as the liquid coolant flows throughout the computing infrastructure through various zones corresponding to flow regulating devices, the temperature of the liquid coolant varies. Controlling the temperature of the liquid coolant by mixing various flows may support zonal cold plates for various zones of the computing infrastructure.

At block 866, the microcontroller determines a state (e.g., a valve state, a pump state) of the flow-regulating device for a cold loop and, at block 868, determines a state (e.g., a valve state, a pump state) of the flow-regulating device for a hot loop. At block 870, the states of the flow-regulating devices for the cold loop and hot loop are received by the microcontroller. At block 872, a PI controller receives the states information and, at block 874, calculates a corrected PMW. At block 876, the liquid coolant is mixed so that, at block 878, the desired flow rate and component temperature (e.g., the predetermined setpoint) is achieved. At block 880, the process 800 stops.

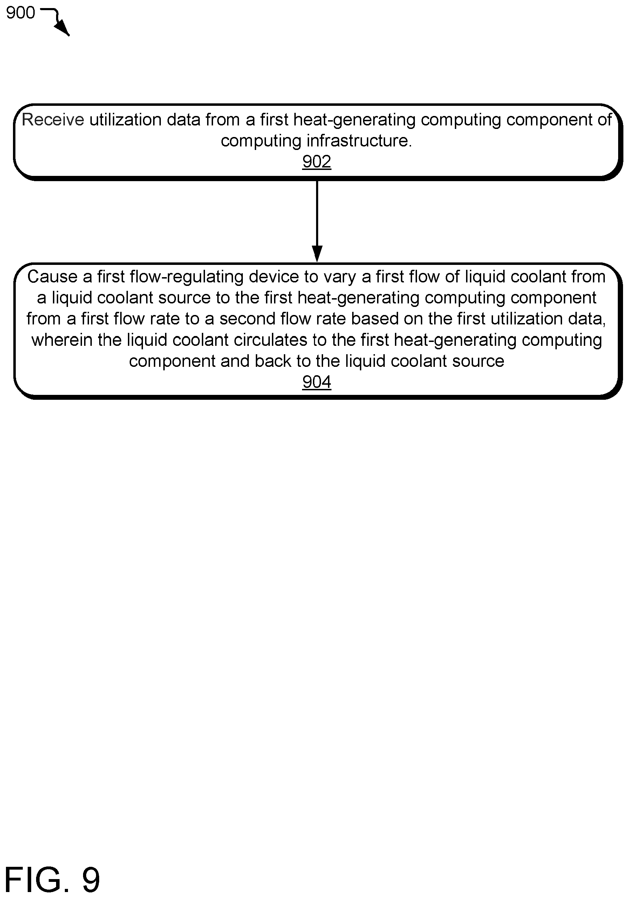

FIG. 9 depicts examples of operations 900 for providing liquid coolant to computing infrastructure based on utilization data of the computing infrastructure. The example operations 900 are, in some implementations, performed by a liquid cooling system.

An example receiving operation 902 receives utilization data from a first heat-generating computing component of computing infrastructure. In some implementations, the first heat-generating computing component comprises a computing device, a computing device component, or a plurality of computing devices of a rack. In some implementations, the liquid coolant source includes water.

An example causing operation 904 causes a first flow-regulating device to vary a first flow of liquid coolant from a liquid coolant source to the first heat-generating computing component from a first flow rate to a second flow rate based on the first utilization data, wherein the liquid coolant circulates to the first heat-generating computing component and back to the liquid coolant source. In some implementations, second utilization data is received from a second heat-generating computing component of the computing infrastructure, wherein the first heat-generating computing component and the second heat-generating computing component are subcomponents of a common heat-generating computing component of the computing infrastructure, and a second flow of the liquid coolant from the liquid coolant source to the second heat-generating computing component is varied based on the second utilization data. In some implementations, the first flow-regulating device comprises a variable pump or a flow control valve. In some implementations the second flow rate is determined, the second flow rate achieving a predetermined setpoint for the first flow. In some implementations, a temperature of the liquid coolant leaving the first heat-generating computing component is determined, wherein the first flow is varied from the first flow rate to the second flow rate based on the temperature.

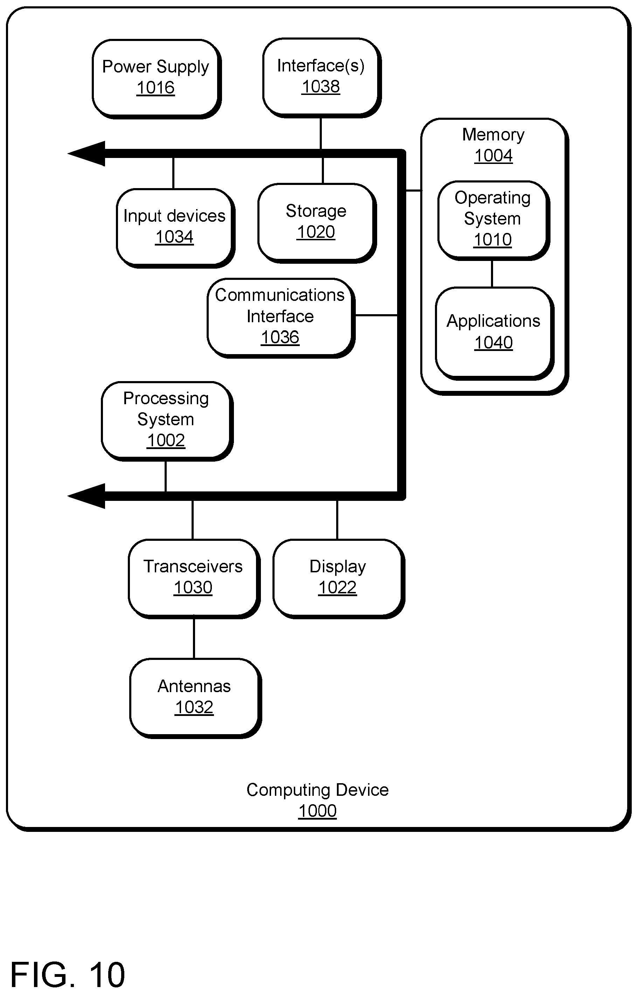

FIG. 10 illustrates an example computing device 1000 for use in implementing the described technology. The computing device 1000 may be a client computing device (such as a laptop computer, a desktop computer, or a tablet computer), a server/cloud computing device, an Internet-of-Things (IoT), any other type of computing device, or a combination of these options. The computing device 1000 includes one or more hardware processor(s) 1002 and a memory 1004. The memory 1004 generally includes volatile memory (e.g., RAM) and nonvolatile memory (e.g., flash memory), although one or the other type of memory may be omitted. An operating system 1010 resides in the memory 1004 and is executed by the processor(s) 1002. In some implementations, the computing device 1000 includes and/or is communicatively coupled to storage 1020.

In the example computing device 1000, as shown in FIG. 10, one or more software modules, segments, and/or processors, such as applications 1040, a liquid cooling system, computing infrastructure, servers, components of a server, controllers, coolant distribution systems, flow-regulating devices, microcontrollers, PI controllers, comparators, sensors, and other program code and modules are loaded into the operating system 1010 on the memory 1004 and/or the storage 1020 and executed by the processor(s) 1002. The storage 1020 may store utilization data, sensor data (e.g., temperature data, pressure data, flow rate data), setpoints, errors, control gain, hot and cold flow rates, hot and cold PMWs, flow-regulating device states, and other data and be local to the computing device 1000 or may be remote and communicatively connected to the computing device 1000. In particular, in one implementation, components of a system for guiding the collection of information for input into an electronic record via a user computing device may be implemented entirely in hardware or in a combination of hardware circuitry and software.

The computing device 1000 includes a power supply 1016, which may include or be connected to one or more batteries or other power sources and which provides power to other components of the computing device 1000. The power supply 1016 may also be connected to an external power source that overrides or recharges the built-in batteries or other power sources.

The computing device 1000 may include one or more communication transceivers 1030, which may be connected to one or more antenna(s) 1032 to provide network connectivity (e.g., mobile phone network, Wi-Fi^{®}, Bluetooth^{®}) to one or more other servers, client devices, IoT devices, and other computing and communications devices. The computing device 1000 may further include a communications interface 1036 (such as a network adapter or an I/O port, which are types of communication devices). The computing device 1000 may use the adapter and any other types of communication devices for establishing connections over a wide-area network (WAN) or local-area network (LAN). It should be appreciated that the network connections shown are exemplary and that other communications devices and means for establishing a communications link between the computing device 1000 and other devices may be used.

The computing device 1000 may include one or more input devices 1034 such that a user may enter commands and information (e.g., a keyboard, trackpad, or mouse). These and other input devices may be coupled to the server by one or more interfaces 1038, such as a serial port interface, parallel port, or universal serial bus (USB). The computing device 1000 may further include a display 1022, such as a touchscreen display.

The computing device 1000 may include a variety of tangible processor-readable storage media and intangible processor-readable communication signals. Tangible processor-readable storage can be embodied by any available media that can be accessed by the computing device 1000 and can include both volatile and nonvolatile storage media and removable and non-removable storage media. Tangible processor-readable storage media excludes intangible, transitory communications signals (such as signals per se) and includes volatile and nonvolatile, removable, and non-removable storage media implemented in any method, process, or technology for storage of information such as processor-readable instructions, data structures, program modules, or other data. Tangible processor-readable storage media includes, but is not limited to, RAM, ROM, EEPROM, flash memory or other memory technology, CDROM, digital versatile disks (DVD) or other optical disk storage, magnetic cassettes, magnetic tape, magnetic disk storage, or other magnetic storage devices, or any other tangible medium which can be used to store the desired information and which can be accessed by the computing device 1000. In contrast to tangible processor-readable storage media, intangible processor-readable communication signals may embody processor-readable instructions, data structures, program modules, or other data resident in a modulated data signal, such as a carrier wave or other signal transport mechanism. The term "modulated data signal" means a signal that has one or more of its characteristics set or changed in such a manner as to encode information in the signal. By way of example, and not limitation, intangible communication signals include signals traveling through wired media such as a wired network or direct-wired connection, and wireless media such as acoustic, RF, infrared, and other wireless media.

Clause 1. A liquid cooling system, comprising: a liquid coolant source; a first heat-generating computing component of a computing system; a first flow-regulating device configurable to vary a first flow of liquid coolant from the liquid coolant source to the first heat-generating computing component of computing infrastructure, wherein the liquid coolant circulates to the first heat-generating computing component and back to the liquid coolant source; and a first controller configured to cause the first flow-regulating device to vary the first flow from a first flow rate to a second flow rate based on first utilization data received from the first heat-generating computing component.

Clause 2. The liquid cooling system of clause 1, wherein the first heat-generating computing component comprises a computing device, a computing device component, or a plurality of computing devices of a rack.

Clause 3. The liquid cooling system of clause 1, further comprising: a second flow-regulating device configurable to vary a second flow of the liquid coolant from the liquid coolant source to a second heat-generating computing component of the computing infrastructure, wherein the first heat-generating computing component and the second heat-generating computing component are subcomponents of a common heat-generating computing component of the computing infrastructure; and a second controller configured to cause the second flow-regulating device to vary a flow rate of the second flow based on second utilization data received from the second heat-generating computing component.

Clause 4. The liquid cooling system of clause 1, wherein the first flow-regulating device comprises a variable pump or a flow control valve.

Clause 5. The liquid cooling system of clause 1, further comprising: a temperature sensor configured to determine a temperature of the liquid coolant leaving the first heat-generating computing component; and wherein the first controller is further configured to vary the first flow from the first flow rate to the second flow rate based on the temperature.

Clause 6. The liquid cooling system of clause 1, further comprising: a flow rate sensor to determine the first flow rate, wherein the first controller is further configured to: determine the second flow rate, the second flow rate achieving a predetermined setpoint for the first flow.

Clause 7. The liquid cooling system of clause 1, wherein the liquid coolant source includes water.

Clause 8. A method comprising: receiving first utilization data from a first heat-generating computing component of computing infrastructure; and causing a first flow-regulating device to vary a first flow of liquid coolant from a liquid coolant source to the first heat-generating computing component from a first flow rate to a second flow rate based on the first utilization data, wherein the liquid coolant circulates to the first heat-generating computing component and back to the liquid coolant source.

Clause 9. The method of clause 8, wherein the first heat-generating computing component comprises a computing device, a computing device component, or a plurality of computing devices of a rack.

Clause 10. The method of clause 8, further comprising: receiving second utilization data from a second heat-generating computing component of the computing infrastructure, wherein the first heat-generating computing component and the second heat-generating computing component are subcomponents of a common heat-generating computing component of the computing infrastructure; and varying a second flow of the liquid coolant from the liquid coolant source to the second heat-generating computing component based on the second utilization data.

Clause 11. The method of clause 8, wherein the first flow-regulating device comprises a variable pump or a flow control valve.

Clause 12. The method of clause 8, the second flow rate achieving a predetermined setpoint for the first flow.

Clause 13. The method of clause 8, wherein the liquid coolant source includes water.

Clause 14. One or more tangible processor-readable storage media embodied with instructions for executing on one or more processors and circuits of a computing device a process comprising: receiving first utilization data from a first heat-generating computing component of computing infrastructure; and causing a first flow-regulating device to vary a first flow of liquid coolant from a liquid coolant source to the first heat-generating computing component from a first flow rate to a second flow rate based on the first utilization data, wherein the liquid coolant circulates to the first heat-generating computing component and back to the liquid coolant source.

Clause 15. The one or more tangible processor-readable storage media of clause 14, wherein the first heat-generating computing component comprises another computing device, a computing device component, or a plurality of computing devices of a rack.

Clause 16. The one or more tangible processor-readable storage media of clause 14, wherein the liquid coolant source includes water.

Clause 17. The one or more tangible processor-readable storage media of clause 14, the process further comprising: receiving second utilization data from a second heat-generating computing component of the computing infrastructure, wherein the first heat-generating computing component and the second heat-generating computing component are subcomponents of a common heat-generating computing component of the computing infrastructure; and varying a second flow of the liquid coolant from the liquid coolant source to the second heat-generating computing component based on the second utilization data.

Clause 18. The one or more tangible processor-readable storage media of clause 14, wherein the first flow-regulating device comprises a variable pump or a flow control valve.

Clause 19. The one or more tangible processor-readable storage media of clause 14, the second flow rate achieving a predetermined setpoint for the first flow.

Clause 20. The one or more tangible processor-readable storage media of clause 14, the process further comprising determining a temperature of the liquid coolant leaving the first heat-generating computing component, wherein the first flow is varied from the first flow rate to the second flow rate based on the temperature.

Clause 21. A liquid cooling system, comprising: a liquid coolant source; a first-heat generating computing component; means for varying a first flow of liquid coolant from the liquid coolant source to the first heat-generating computing component of computing infrastructure, wherein the liquid coolant circulates to the first heat-generating computing component and back to the liquid coolant source; and means for causing the first flow-regulating device to vary the first flow from a first flow rate to a second flow rate based on first utilization data received from the first heat-generating computing component.

Clause 22. The liquid cooling system of clause 21, wherein the first heat-generating computing component comprises a computing device, a computing device component, or a plurality of computing devices of a rack.

Clause 23. The liquid cooling system of clause 21, further comprising: means for varying a second flow of the liquid coolant from the liquid coolant source to a second heat-generating computing component of the computing infrastructure, wherein the first heat-generating computing component and the second heat-generating computing component are subcomponents of a common heat-generating computing component of the computing infrastructure; and means for causing the second flow-regulating device to vary a flow rate of the second flow based on second utilization data received from the second heat-generating computing component.

Clause 24. The liquid cooling system of clause 21, wherein the means for varying the first flow comprises a variable pump or a flow control valve.

Clause 25. The liquid cooling system of clause 21, further comprising: means for determining a temperature of the liquid coolant leaving the first heat-generating computing component; and wherein the means for varying the first flow is further configured to vary the first flow from the first flow rate to the second flow rate based on the temperature.

Clause 26. The liquid cooling system of clause 21, further comprising: means for determining the first flow rate, wherein the means for varying the first flow is further configured to: determine the second flow rate, the second flow rate achieving a predetermined setpoint for the first flow.

Clause 27. The liquid cooling system of clause 21, wherein the liquid coolant source includes water.

Clause 28. A liquid cooling system may include a liquid coolant source. The liquid cooling system may include a first heat-generating computing component of a computing system. The liquid cooling system may include a first flow-regulating device configurable to vary a first flow of liquid coolant from the liquid coolant source to the first heat-generating computing component of computing infrastructure, wherein the liquid coolant circulates to the first heat-generating computing component and back to the liquid coolant source. The liquid cooling system may include a first controller configured to cause the first flow-regulating device to vary the first flow from a first flow rate to a second flow rate based on first utilization data received from the first heat-generating computing component.

Some implementations may comprise an article of manufacture, which excludes software per se. An article of manufacture may comprise a tangible storage medium to store logic and/or data. Examples of a storage medium may include one or more types of computer-readable storage media capable of storing electronic data, including volatile memory or nonvolatile memory, removable or non-removable memory, erasable or non-erasable memory, writeable or re-writeable memory, and so forth. Examples of the logic may include various software elements, such as software components, programs, applications, computer programs, application programs, system programs, machine programs, operating system software, middleware, firmware, software modules, routines, subroutines, operation segments, methods, procedures, software interfaces, application program interfaces (API), instruction sets, computing code, computer code, code segments, computer code segments, words, values, symbols, or any combination thereof. In one implementation, for example, an article of manufacture may store executable computer program instructions that, when executed by a computer, cause the computer to perform methods and/or operations in accordance with the described embodiments. The executable computer program instructions may include any suitable types of code, such as source code, compiled code, interpreted code, executable code, static code, dynamic code, and the like. The executable computer program instructions may be implemented according to a predefined computer language, manner, or syntax, for instructing a computer to perform a certain operation segment. The instructions may be implemented using any suitable high-level, low-level, object-oriented, visual, compiled, and/or interpreted programming language.

The implementations described herein are implemented as logical steps in one or more computer systems. The logical operations may be implemented (1) as a sequence of processor-implemented steps executing in one or more computer systems and (2) as interconnected machine or circuit modules within one or more computer systems. The implementation is a matter of choice, dependent on the performance requirements of the computer system being utilized. Accordingly, the logical operations making up the implementations described herein are referred to variously as operations, steps, objects, or modules. Furthermore, it should be understood that logical operations may be performed in any order, unless explicitly claimed otherwise or a specific order is inherently necessitated by the claim language.

## Claims

1. A liquid cooling system (502) (402) (302) (202) (102), comprising:
a liquid coolant source;
a first heat-generating computing component of a computing system;
a first flow (104)-regulating device (650) (524-3) (524-2) (524-1) (514-N) (514-4) (514-3) (514-2) (514-1) (424-3) (424-2) (424-1) (314-N) (314-4) (314-3) (314-2) (314-1) (226-2) (226-1) configurable to vary a first flow (104) of liquid coolant from the liquid coolant source to the first heat-generating computing component of computing infrastructure (106), wherein the liquid coolant circulates to the first heat-generating computing component and back to the liquid coolant source; and
a first controller (606) configured to cause the first flow (104)-regulating device (650) (524-3) (524-2) (524-1) (514-N) (514-4) (514-3) (514-2) (514-1) (424-3) (424-2) (424-1) (314-N) (314-4) (314-3) (314-2) (314-1) (226-2) (226-1) to vary the first flow (104) from a first flow (104) rate to a second flow (104) rate based on first utilization data (526-3) (526-2) (526-1) (508-1) (408-3) (408-2) (408-1) (308-N) (308-4) (308-3) (308-2) (308-1) (208) (108) received from the first heat-generating computing component.

2. The liquid cooling system of claim 1, wherein the first heat-generating computing component comprises a computing device, a computing device component, or a plurality of computing devices of a rack.

3. The liquid cooling system of claim 1 or claim 2, further comprising:
a second flow-regulating device configurable to vary a second flow of the liquid coolant from the liquid coolant source to a second heat-generating computing component of the computing infrastructure, wherein the first heat-generating computing component and the second heat-generating computing component are subcomponents of a common heat-generating computing component of the computing infrastructure; and
a second controller configured to cause the second flow-regulating device to vary a flow rate of the second flow based on second utilization data received from the second heat-generating computing component.

4. The liquid cooling system of any preceding claim, wherein the first flow-regulating device comprises a variable pump or a flow control valve.

5. The liquid cooling system of any preceding claim, further comprising:
a temperature sensor configured to determine a temperature of the liquid coolant leaving the first heat-generating computing component; and wherein the first controller is further configured to vary the first flow from the first flow rate to the second flow rate based on the temperature.

6. The liquid cooling system of any preceding claim, further comprising:
a flow rate sensor to determine the first flow rate, wherein the first controller is further configured to:
determine the second flow rate, the second flow rate achieving a predetermined setpoint for the first flow.

7. The liquid cooling system of any preceding claim, wherein the liquid coolant source includes water.

8. A method comprising:
receiving (902) first utilization data (526-3) (526-2) (526-1) (508-1) (408-3) (408-2) (408-1) (308-N) (308-4) (308-3) (308-2) (308-1) (208) (108) from a first heat-generating computing component of computing infrastructure (106); and
causing (904) a first flow (104)-regulating device (650) (524-3) (524-2) (524-1) (514-N) (514-4) (514-3) (514-2) (514-1) (424-3) (424-2) (424-1) (314-N) (314-4) (314-3) (314-2) (314-1) (226-2) (226-1) to vary a first flow (104) of liquid coolant from a liquid coolant source to the first heat-generating computing component from a first flow (104) rate to a second flow (104) rate based on the first utilization data (526-3) (526-2) (526-1) (508-1) (408-3) (408-2) (408-1) (308-N) (308-4) (308-3) (308-2) (308-1) (208) (108), wherein the liquid coolant circulates to the first heat-generating computing component and back to the liquid coolant source.

9. The method of claim 8, wherein the first heat-generating computing component comprises a computing device, a computing device component, or a plurality of computing devices of a rack.

10. The method of claim 8 or claim 9, further comprising:
receiving second utilization data from a second heat-generating computing component of the computing infrastructure, wherein the first heat-generating computing component and the second heat-generating computing component are subcomponents of a common heat-generating computing component of the computing infrastructure; and
varying a second flow of the liquid coolant from the liquid coolant source to the second heat-generating computing component based on the second utilization data.

11. The method of any of claims 8 to 10, wherein the first flow-regulating device comprises a variable pump or a flow control valve.

12. The method of any of claims 8 to 11, the second flow rate achieving a predetermined setpoint for the first flow.

13. The method of any of claims 8 to 12, wherein the liquid coolant source includes water.

14. One or more tangible processor-readable storage (1020) media embodied with instructions for executing on one or more processors (1002) and circuits of a computing device (1000) a process (800) (700) comprising:
receiving (902) first utilization data (526-3) (526-2) (526-1) (508-1) (408-3) (408-2) (408-1) (308-N) (308-4) (308-3) (308-2) (308-1) (208) (108) from a first heat-generating computing component of computing infrastructure (106); and
causing (904) a first flow (104)-regulating device (650) (524-3) (524-2) (524-1) (514-N) (514-4) (514-3) (514-2) (514-1) (424-3) (424-2) (424-1) (314-N) (314-4) (314-3) (314-2) (314-1) (226-2) (226-1) to vary a first flow (104) of liquid coolant from a liquid coolant source to the first heat-generating computing component from a first flow (104) rate to a second flow (104) rate based on the first utilization data (526-3) (526-2) (526-1) (508-1) (408-3) (408-2) (408-1) (308-N) (308-4) (308-3) (308-2) (308-1) (208) (108), wherein the liquid coolant circulates to the first heat-generating computing component and back to the liquid coolant source.

15. The one or more tangible processor-readable storage media of claim 14, wherein the first heat-generating computing component comprises another computing device, a computing device component, or a plurality of computing devices of a rack.
